(19) Europäisches Patentamt
European Patent Office
Office européen des brevets

(11) Veröffentlichungsnummer : **0 050 224**
**B1**

(12) # EUROPÄISCHE PATENTSCHRIFT

(45) Veröffentlichungstag der Patentschrift : **09.01.85**

(51) Int. Cl.⁴ : **G 03 F 7/10**, G 03 C 1/70

(21) Anmeldenummer : **81107481.4**

(22) Anmeldetag : **21.09.81**

(54) **Fotopolymere Reliefformen und Verfahren zu deren Herstellung.**

(30) Priorität : **17.10.80 DE 3039209**

(43) Veröffentlichungstag der Anmeldung : **28.04.82 Patentblatt 82/17**

(45) Bekanntmachung des Hinweises auf die Patenterteilung : **09.01.85 Patentblatt 85/02**

(84) Benannte Vertragsstaaten : **BE DE FR GB**

(56) Entgegenhaltungen :
**EP-A- 0 002 321**
**EP-A- 0 010 690**
**Die Akte enthält technische Angaben, die nach dem Eingang der Anmeldung eingereicht wurden und die nicht in dieser Patentschrift enthalten sind.**

(73) Patentinhaber : **BASF Aktiengesellschaft**
**Carl-Bosch-Strasse 38**
**D-6700 Ludwigshafen (DE)**

(72) Erfinder : **Hoffmann, Gerhard, Dr. Dipl.-Chem.**
**Pappelstrasse 22**
**D-6701 Otterstadt (DE)**
Erfinder : **Kleuser, Dieter, Dr. Dipl.-Chem.**
**Pierstrasse 4**
**D-6710 Frankenthal (DE)**
Erfinder : **Lenz, Werner, Dr. Dipl.-Chem.**
**Heinrich-Baermann-Strasse 14**
**D-6702 Bad Duerkheim (DE)**

**EP 0 050 224 B1**

Anmerkung : Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

Jouve, 18, rue St-Denis, 75001 Paris, France

**Beschreibung**

Die Erfindung betrifft ein Verfahren zur Herstellung von fotopolymeren Reliefformen durch schichtförmiges Auftragen einer fotoinitiator und Polymerisationsinhibitor enthaltenden Mischung einer fotopolymerisierbaren Verbindung auf einen mit einer speziellen Haftschicht versehenen Träger, bildmäßiges Belichten der aufgetragenen Schicht und Entfernen der unbelichteten Schichtanteile.

Die Herstellung von fotopolymeren Reliefformen durch bildmäßiges Belichten von fotovernetzbaren Schichten, die auf einen mit einer Haftschicht versehenen Träger aufgetragen sind, ist an sich bekannt, wobei die fotovernetzbaren Schichten fest oder flüssig sein können. Die Herstellung von Druckplatten unter Auftragen von flüssigen, fotovernetzbaren Schichten ist z. B. in den DE-OS 2 040 390, 2 316 401, 2 408 748, 2 414 596, 2 415 728 und 2 659 699 beschrieben. Aus den DE-OS 2 414 596 und 2 415 728 ist auch bekannt, die reliefbildende, fotovernetzbare bzw. fotopolymerisierbare Schicht auf Träger aufzubringen, die zuvor mit mindestens einer speziellen Haftschicht versehen wurden. Bei der Herstellung von solchen fotopolymeren Reliefformen durch bildmäßiges Belichten von fotovernetzbaren Schichten mit UV-Licht mit einem gewissen Streulichtanteil zeigt sich, daß die resultierende Reliefstruktur der entwickelten fotopolymeren Reliefformen häufig ungenügend ist. Es wurde festgestellt, daß der Belichtungsspielraum solcher Platten, d. h. die Differenz der oberen und unteren Belichtungsgrenze, die zur Bildung einer befriedigenden Reliefstruktur führt, von der Stärke der reliefbildenden Schicht R (Reliefstärke) und von der Vorgeschichte der aufghetragenen fotovernetzbaren Mischung abhängig ist. Überraschenderweise wird der Belichtungsspielraum mit abnehmender Schicht- bzw. Reliefstärke (1,0 mm-0,8 mm-0,5 mm) immer schlechter und weist bei einer Schicht- bzw. Reliefstärke von 0,5 mm schon eine kritische Größenordnung des Belichtungsspielraumes auf, was leicht zu unbefriedigenden Reliefstrukturen und Reklamationen führt. Auch das Alter und die Lagerung der fotovernetzbaren Mischungen für die reliefbildende Schicht vor der Schichtherstellung bzw. vor dem bildmäßigen Belichten der reliefbildenden Schicht wirken sich nachteilig auf den zulässigen Belichtungsspielraum für die Herstellung befriedigender Reliefstrukturen aus.

Der vorliegenden Erfindung lag die Aufgabe zugrunde, im bekannten Verfahren zur Herstellung von fotopolymeren Reliefformen durch bildmäßiges Belichten einer auf einen mit einer Haftschicht versehenen Träger aufgetragenen fotovernetzbaren Schicht und nachfolgendes Entfernen der unbelichteten Schichtanteile den Belichtungsspielraum zu verbessern, ohne daß Polymere und/oder Monomer in der fotovernetzbaren Schicht und festgelegte Reliefstärken der Platten geändert oder die unter Belichtungsgrenze verlängert werden.

Es wurde nun gefunden, daß die Aufgabe gelöst werden kann mit einem Verfahren zur Herstellung von fotopolymeren Reliefformen durch Auftragen einer lichtempfindlichen reliefbildenden Schicht R einer einen Fotoinitiator enthaltenden Mischung einer fotopolymerisierbaren ethylenisch ungesättigten Verbindung auf einen dimensionsstabilen Träger, der mit einer haftvermittelnden Schicht H für die Schicht R versehen ist, bildmäßiges Belichten der Schicht R und nachfolgendes Entfernen der unbelichteten Schichtanteile, das dadurch gekennzeichnet ist, daß eine 0,000 01 bis 5 Gewichtsprozent eines bei UV-Bestrahlung Nitrosylradikale freisetzenden Polymerisationsinhibitors enthaltende Schicht R auf eine haftvermittelnde Schicht H aufgetragen wird, die 0,01 bis 10 Gewichtsprozent einer Verbindung

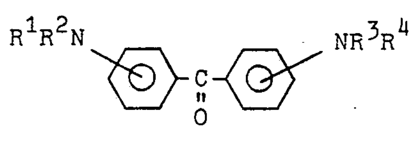

enthält, worin $R^1$ bis $R^4$ Alkylreste oder $R^5$-(O-alkylen)$_x$-Reste, mit $R^5$ = H oder Alkyl und X = 1 bis 5, gleicher oder verschiedener Art darstellen.

Gegenstand der Erfindung sind neben dem vorstehend gekennzeichneten Verfahren Reliefformen, die gemäß dem Verfahren hergestellt sind.

Als einen Fotoinitiator enthaltende Mischung einer fotopolymerisierbaren ethylenisch ungesättigten Verbindung für die reliefbildende Schicht eignen sich die bekannten für fotopolymere Druckplatten verwendeten Fotoinitiator enthaltenden ethylenisch ungesättigten Monomeren sowie entsprechende Mischungen, die solche Monomere und ungesättigte und/oder gesättigte polymere Bindemittel enthalten. Besonders geeignet ist das erfindungsgemäße Verfahren für flüssige Mischungen von Fotoinitiator enthaltenden Monomer/Polymer-Mischungen und insbesondere wässrig-alkalisch entwickelbare Mischungen, wie sie in den DE-OS 2 040 390 oder DE-OS 2 659 699 beschrieben sind. Von den durch Umsetzung von ungesättigten und ggf. gesättigten zwei- und ggf. mehrbasischen Carbonsäuren mit Di- und ggf. Polyalkoholen hergestellten Polyestern linearer oder verzweigter Natur sind solche mit einer höheren Säurezahl und insbesondere einer Säurezahl zwischen 75 und 160 bevorzugt, da sie in den Massen zu einer guten Dispergierbarkeit oder Löslichkeit in alkalisch-wäßrigen Entwicklerlösungsmitteln führen. Bezüglich der Zusammensetzung und Herstellung von ungesättigten Polyesterharzen sei auf die vorhandene Literatur, z. B. das Buch von H.V. Boenig, Unsaturated Polyesters, Structure and Properties, Amsterdam 1964, verwiesen.

Der Gehalt der Mischung an polymerem Bindemittel beträgt im allgemeinen etwa 45 bis 90 und insbesondere 45 bis 65 Gewichtsprozent, bezogen auf die Menge an Polymerem und photopolymerisierbaren Monomeren.

Als fotopolymerisierbare, ethylenisch ungesättigte Verbindungen für die Schicht R sind vor allem die niedermolekularen Verbindungen mit mindestens einer ethylenisch ungesättigten, fotopolymerisierbaren Doppelbindung geeignet, soweit sie mit den jeweils gewählten polymeren Bindemitteln verträgliche Mischungen bilden und einen Siedepunkt von über 100 °C bei Atmosphärendruck haben. Bevorzugt sind Monomere mit zwei- oder mehr ethylenisch ungesättigten fotopolymerisierbaren Doppelbindungen allein oder deren Mischungen mit Monomeren mit nur einer ethylenisch ungesättigten fotopolymerisierbaren Doppelbindung. Die Art der verwendeten Monomeren richtet sich weitgehend nach der Art des mitverwendeten polymeren Bindemittels. So sind bei Mischungen mit ungesättigten Polyesterharzen besonders zwei oder mehr Doppelbindungen enthaltende Allylverbindungen, wie Maleinsäurediallylester, Allylacrylat, Diallylphthalat, Trimellithsäuredi- und -triallylester oder Äthylenglykolbisallylcarbonat, sowie Di- und Polyacrylate und -methacrylate geeignet, wie sie durch Veresterung von Diolen oder Polyolen mit Acrylsäure oder Methacrylsäure hergestellt werden können, wie die Di- und Tri(meth)-acrylate von Äthylenglykol, Diäthylenglykol, Triäthylenglykol, Polyäthylenglykol mit einem Molekulargewicht bis etwa 800, 1,2-Propandiol, 1,3-Propandiol, Neopentylglykol (2,2-Dimethyl-propandiol), 1,4-Butandiol, 1,1,1-Trimethylolpropan, Glycerin oder Pentaerythrit ; ferner die Monoacrylate und Monomethacrylate solcher Diole und Polyole, wie z. B. Äthylenglykol- oder Di-, Tri- oder Tetraäthylenglykol-monoacrylat, Monomere mit zwei- oder mehr olefinisch ungesättigten Bindungen, die Urethangruppen und/oder Amidgruppen enthalten, wie die aus aliphatischen Diolen der vorstehend genannten Art, organischen Diisocyanaten und Hydroxyalkyl-(meth)acrylaten hergestellten niedermolekularen Verbindungen. Genannt sein auch Acrylsäure, Methacrylsäure sowie deren Derivate wie (Meth)acrylamid, N-Hydroxymethyl(meth)-acrylamid oder (Meth)acrylate von Monoalkoholen mit 1 bis 6 C-Atomen. Mischungen von Allylmonomeren mit Di- oder Polyacrylaten sind sehr geeignet.

Die Menge an dem Monomeren oder den Monomeren beträgt bevorzugt etwa 10 bis 55 und insbesondere 35 bis 55 Gewichtsprozent, bezogen auf die Menge an Polymerem und fotopolymerisierbaren Monomeren und wird u.a. von ihrer Verträglichkeit mit dem Polymeren und der gewünschten Härte der resultierenden Druckform bestimmt. Sehr geeignet sind Mischungen, die 45 bis 75 Gewichtsprozent eines ungesättigten Polyesters einer Säurezahl von 100 bis 150, 15 bis 25 und insbesondere 10 bis 20 Gewichtsprozent eines mindestens eine Allylgruppe enthaltenden Monomeren mit zwei C-C-Doppelbindungen, 5 bis 25 Gewichtsprozent eines Monomeren mit mindestens einer (Meth)acrylat-Gruppe, 1 bis 10 Gewichtsprozent einer niedermolekularen Verbindung mit mindestens einer Amidgruppe, 0,2 bis 4 Gewichtsprozent eines Fotoinitiators sowie in einer Menge unter 1 Gewichtsprozent einen thermischen Polymerisationsinhibitor enthalten.

Die Schicht R enthält in an sich bekannter Art in Mengen von 0,01 bis 10 und insbesondere 0,01 bis 3 Gewichtsprozent, bezogen auf die genannte Mischung, einen Fotoinitiator. Als Fotoinitiator sind praktisch alle Verbindungen geeignet, die bei Einwirkung von aktinischem Licht Radikale zu bilden vermögen, die eine Polymerisation auslösen. Als Fotoinitiatoren kommen z. B. in Frage Acyloine und Acyloinäther, aromatische Diketone und deren Derivate, mehrkernige Chinone, Acridinderivate, Phenazinderivate. Sehr geeignet sind Benzoin- und α-Hydroxymethylbenzoin sowie deren Alkyläther mit 1 bis 8 C-Atomen, wie Benzoinisopropyläther, α-Hydroxymethyl-benzoinmethyläther, Benzointetrahydropyranyläther oder Benzoinmethyl-äther, Benzilmonoketale, wie Benzil-monomethyl-benzylketal oder Benzilmono-neopentylketal.

Erfindungsgemäß enthält die Mischung für die reliefbildende Schicht R in einer Menge von 0,000 01 bis 5 und insbesondere 0,000 1 bis 3 Gewichtsprozent eines bei UV-Bestrahlung Nitrosylradikale freisetzenden thermischen Polymerisationsinhibitors. Als solche eignen sich vor allem die in der DE-AS 24 37 632 genannten Nitrosamine und insbesondere das N-Nitrosodiphenylamin.

Die Mischungen für die Schicht R können auch weitere übliche Zusätze enthalten, wie Weichmacher, gesättigte niedermolekulare Verbindungen mit Amidgruppen, Wachse usw.

Die Verarbeitung der fotopolymerisierbaren Mischungen zu Fotopolymerdruckplatten, die schichtförmig die Mischungen als reliefformende Schichten R im allgemeinen in einer Schichtstärke von 0,2 bis 3 mm und insbesondere 0,4 bis 1,5 mm aufweisen, kann in an sich bekannter Weise erfolgen und ist von der Art der Mischung abhängig. Flüssige Mischungen können mit einer Rakel auf die mit mindestens einer haftvermittelnden Schicht H versehenen Träger aufgetragen werden.

Als dimensionsstabile Träger kommen für die Herstellung von Reliefformen als Träger bekannte Grundplatten in Frage, wie Eisen- oder Aluminiumbleche oder zähe Kunststoffolien, wie Polyester-, Polyvinylchlorid- oder Cellulosefilme, die mit einer haftvermittelnden Schicht H für die Schicht R versehen ist. Träger mit geeigneten haftvermittelnden Schichten sind besonders in den DE-OS 15 97 515, 24 14 596 und 24 15 728. Als Haftlacke für die haftvermittelnde Schicht H haben sich recht gut Polyurethan-Lacke und besonders pigmenthaltige Polyurethan-Lacke bewährt, die neben hydroxylgruppenhaltigen Oligomeren oder Polymeren, wie hydroxylgruppenhaltigen Polyestern oder Epoxidharzen, Polyisocyanat, bevorzugt im Überschuß, enthalten und, ggf. in Gegenwart von Katalysatoren für die Polyurethanbildung, beim oder nach dem Auftrag, bevorzugt unter Erwärmen des mit Haftschicht versehenen Trägers, unter Vernetzung reagieren. Als hydroxylgruppenhaltige Polyester eignen sich die in

der DE-OS 15 97 515 angegebenen. Vorteilhaft ist ein Gehalt der Schicht H an einem ungesättigten Monomeren, wie Glycidyl(meth)acrylat oder einem acrylierten Epoxidharz.

Oft hat es sich auch als zweckmäßig erwiesen, erst einen haftvermittelnden Grundlack auf den Träger aufzubringen, der vor allem bezüglich der Haftung mit dem träger dienlich ist, und auf diesen eine zweite Haftschicht aufzubringen, die der Haftung mit der reliefformenden Schicht R besonders dienlich ist, d. h. oft ein chemisch ähnliches Strukturprinzip beim Bindemittel aufweist. Die Art der Bindemittel oder Bindemittel bildenden und der sonstigen Bestandteile der haftvermittelnden Schicht H richten sich nach der Art des Trägers und der Art der Mischung der Schicht R und sind für sich nicht Gegenstand dieser Erfindung.

Wesentlich im Sinne der Erfindung ist jedoch, daß die haftvermittelnde Schicht H, im Fall des Auftrags von zwei haftvermittelnden Schichten auf den Träger zumindest die der Schicht R zugewandte haftvermittelnde Schicht H, in einer Menge von 0,01 bis 10 und insbesonders von 0,2 bis 2,0 Gewichtsprozent eine Verbindung der Formel

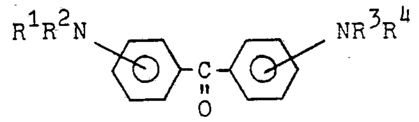

enthält, worin $R^1$ bis $R^4$ Alkylreste oder $R^5$-(O-Alkylen)$_x$-Reste mit $R^5 =$ H oder Alkyl und $x = 1$ bis 5 gleicher oder verschiedener Art darstellen. Die haftvermittelnde Schicht H hat somit stets Michlers Keton oder ein ganz ähnlich strukturiertes N-substituiertes Diaminobenzophenon zu enthalten. Bevorzugt ist die Verwendung von Michlers Keton, doch haben sich auch die entsprechenden Äthylenoxid-Umsetzungsprodukte des Diaminobenzophenons bewährt.

Die der Schicht R zugewandte haftvermittelnde Schicht H kann in bekannter Weise, z. B. durch Aufrakeln oder Aufkaschieren auf den Träger aufgebracht werden und wird bevorzugt dann, ggf. unter Erwärmen, getrocknet, bevor die Schicht R aufgetragen wird. Im allgemeinen beträgt die Stärke der getrockneten haftvermittelnden Schicht H 0,005 bis 0,150 und insbesondere 0,015 bis 0,04 mm. Die Verarbeitung der Druckplatten zu Reliefformen erfolgt in bekannter Art durch bildmäßiges Belichten mit aktinischem Licht mit Lichtquellen, die Maxima der Emission im Bereich der Absorption der fotoinitiatoren, im allgemeinen im Bereich von 300 bis 400 nm besitzen oder einen ausreichenden Anteil von Licht dieses Wellenlängenbereiches aufweisen, wie Quecksilbermitteldruckstrahler, aber auch Hoch- und Niederdruckstrahler oder superaktinische Leuchtstoffröhren. Nach der bildmäßigen Belichtung werden die nichtbelichteten Anteile der Schicht in bekannter Art mechanisch entfernt oder bevorzugt mit Entwicklerlösungsmitteln ausgewaschen, die resultierenden Druckformen werden getrocknet und in manchen Fällen zweckmäßigerweise noch voll nachbelichtet. Bezüglich der Verarbeitung von flüssigen Mischungen für die Schicht R sei besonders auf die DE-OS 24 08 748 verwiesen.

Das erfindungsgemäße Verfahren zeichnet sich dadurch aus, daß mit einem größeren Belichtungsspielraum Reliefformen mit guter Reliefstruktur hergestellt werden können. Es ermöglicht zudem die Verarbeitung länger gelagerter Mischungen zu reliefbildenden Schichten R und Reliefformen, die ohne Anwendung der erfindungsgemäßen kennzeichnenden Verfahrensmerkmale meist nicht mehr in üblicher Weise und ohne zusätzlichen meßtechnischen Aufwand zu Druckformen mit befriedigenden Reliefstrukturen verarbeitet werden können.

Die in den nachstehenden Beispielen und Vergleichsversuchen genannten Teile beziehen sich, soweit nicht anders angegeben, auf das Gewicht.

Beispiel 1

1.1. Herstellung des Haftlacks.

24 Teile eines Polyesters aus 2.5 Molen Adipinsäure, 0,5 Mol Phthalsäure und 4 Molen 1,1,1-Trimethylolpropan mit einem OH-Gehalt von 8,8 Gewichtsprozent werden mit 21 Teilen Rutil, 7 Teilen Bleichromat-Pigment, 16 Teilen Xylol und 32 Teilen Butylacetat zu einem Lack verrührt. 45 Teile dieses Lackes (a) werden mit (b) 15 Teilen eines Umsetzungsproduktes von 1 Mol Diglycidäther des Bis(4-hydroxyphenyl)propan-2.2.2 mit 2 Mol Acrylsäure in 4 Teilen Toluol, (c) 18 Teilen einer 1,93 gewichtsprozentigen Lösung von Michlers Keton (MK) in 35 Teilen Xylol und 65 Teilen Butylacetat und (d) 18 Teilen einer 67 gewichtsprozentigen Lösung des handelsüblichen Umsetzungsproduktes von 1 Mol 1,1,1-Trimethylolpropan mit 3 Molen Toluylendiisocyanat in gleichen Teilen von Xylol und Äthylglykolacetat zu einem Haftlack verarbeitet.

1.2 Herstellung der haftvermittelnden Schicht H auf dem Träger

Der Haftlack wird in einer solchen Dicke auf entfettete Stahlbleche aufgebracht, daß nach dem Ablüften der Lösungsmittel bei Raumtemperatur und 2 Minuten Erhitzen bei 220 °C eine Schicht H von 15 bis 20 µm Stärke auf den Stahlblechen verbleibt.

1.3 Auftragen der reliefbildenden Schicht R

Das Auftragen der Schichten R und die Belichtung der resultierenden Elemente erfolgt in der in der DE-OS 24 08 758 beschriebenen Art. Es wird ein frisch hergestelltes Gemisch aus 54 Gewichtsprozent eines ungesättigten Polyesters aus Fumarsäure, Trimellithsäureanhydrid und Diäthylenglykol mit einer Säurezahl von 143, 46 Gewichtsprozent einer Mischung von Diallylphthalat, Methacrylamid und Polyäthylenglykoldimethacrylat, 0,7 Gewichtsprozent Benzoinmethylether und 145 ppm N-Nitrosodiphenylamin in verschiedenen Reliefstärken, nämlich

0,5 mm (Beispiel 1A)
0,8 mm (Beispiel 1B) und
1,0 mm (Beispiel 1C)

schichtförmig aufgetragen.

1.4 Verarbeitung auf Reliefformen

Die Schicht R wird durch ein Negativ bildmäßig belichtet. Danach werden die unbelichteten Anteile der Druckplatte mit wässrig-alkalischer Lösung ausgewaschen. Die Belichtung wird so durchgeführt, daß die untere und die obere Belichtungsgrenzen der einzelnen Platten ermittelt werden kann. Die Differenz zwischen der oberen und der unteren Belichtungsgrenze wird als Beurteilungsmeßgröße für die Güte der Reliefstruktur herangezogen. Die Errgebnisse werden als prozentuale Angabe der Differenz, gemessen an der unteren Belichtungsgrenze, angeführt. Ist die Angabe positif, so existiert ein gewisser Sicherheitsspielraum in der Belichtungszeit. Ist die Angabe negativ, so sind die Druckplatten nicht verwendungsfähig.

Beispiel 1 (1,93 % MK in Lackkomponente C)

| Reliefhöhe (mm) | 0,5 (1A) | 0,8 (1B) | 1,0 (1C) |
|---|---|---|---|
| | + 160 % | + 350 % | + 500 % |

Beispiel 2

Es wird exakt wie in Beispiel 1 verfahren, jedoch wird in Lackkomponente C (siehe 1.1) statt einer 1,93 prozentigen Lösung von Michlers Keton (MK) eine 0,8 prozentige Lösung von MK verwandt.

Beispiel 2 (0,8 % MK in Lackkomponente C)

| Reliefhöhe (mm) | 0,5 (2A) | 0,8 (2B) | 1,0 (2C) |
|---|---|---|---|
| | + 25 % | + 105 % | + 140 % |

Vergleichsversuch 1 (V1)

Es wird exakt wie in Beispiel 1 verfahren, jedoch enthält die Lackkomponente C kein Michlers Keton

V1 (0 % MK in Lackkomponente C)

| Reliefhöhe (mm) | 0,5 (V1A) | 0,8 (V1B) | 1,0 (V1C) |
|---|---|---|---|
| | 45 % | 15 % | ± 0 |

Beispiel 3

Es wird exakt wie in Beispiel 1 verfahren, jedoch wird nicht wie in 1.3 ein frisch hergestelltes, sondern ein 6 Monate gelagertes Gemisch gleicher Art für Schicht R verwandt.

Beispiel 3 (1,93 % MK in Lackkomponente C, 6 Monate gelagert)

| Reliefhöhe (mm) | 0,5 (3A) | 0,8 (3B) | 1,0 (3C) |
|---|---|---|---|
| | 10 % | + 25 % | + 60 % |

Beispiel 4

Es wird exakt wie in Beispiel 2 verfahren, jedoch wird nicht wie in 1.3 ein frisch hergestelltes, sondern ein 6 Monate gelagertes Gemisch gleicher Art für Schicht R verwandt.

Beispiel 4 (0,8 % MK in Lackkomponente C, 6 Monate gelagert)

| Reliefhöhe (mm) | 0,5 (4A) | 0,8 (4B) | 1,0 (4C) |
|---|---|---|---|
| | − 200 % | − 60 % | + 15 % |

Vergleichsversuch 2 (V2)

Es wird exakt wie in Vergleichsversuch 1 (V1) verfahren, jedoch wird nicht wie in 1.3 ein frisch hergestelltes, sondern ein 6 Monate gelagertes Gemisch gleicher Art für Schicht R verwandt.

V2 (0 % MK in Lackkomponente C, 6 Monate gelagert)

| Reliefhöhe (mm) | 0,5 (V2A) | 0,8 (V2B) | 1,0 (V2C) |
|---|---|---|---|
| | − 400 % | − 400 % | − 350 % |

**Ansprüche**

1. Verfahren zur Herstellung von fotopolymeren Reliefformen durch Auftragen einer lichtempfindlichen reliefbildenden Schicht R, einer einen Fotoinitiator enthaltenden Mischung einer fotopolymerisierbaren ethylenisch ungesättigten Verbindung auf einen dimensionsstabilen Träger, der mit einer haftvermittelnden Schicht H für die Schicht R versehen ist, bildmäßiges Belichten der Schicht R und nachfolgendes Entfernen der unbelichteten Schichtanteile, dadurch gekennzeichnet, daß eine 0,000 01 bis 5 Gewichtsprozent eines bei UV-Bestrahlung Nitrosylradikale freisetzenden thermischen Polymerisationsinhibitors enthaltende Schicht R auf eine haftvermittelnde Schicht H aufgetragen wird, die 0,01 bis 10 Gewichtsprozent einer Verbindung

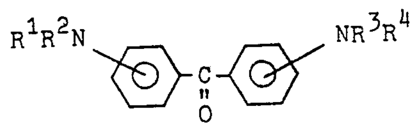

enthält, worin $R^1$ bis $R^4$ Alkylreste oder $R^5$-(O-alkylen)$_x$-Reste, mit $R^5$ = H oder Alkyl und x = 1 bis 5, gleicher oder verschiedener Art darstellen.

2. Verfahren nach Anspruch 1, dadurch gekennzeichnet, daß die Schicht R N-Nitrosodiphenylamin enthält.

3. Verfahren nach Anspruch 1 oder 2, dadurch gekennzeichnet, daß die haftvermittelnde Schicht H Michlers Keton enthält.

4. Verfahren nach einem der Ansprüche 1 bis 3, dadurch gekennzeichnet, daß eine bei Raumtemperatur flüssige Schicht R aufgetragen wird.

5. Verfahren nach einem der Ansprüche 1 bis 4, dadurch gekennzeichnet, daß die Schicht R einen carboxylgruppenhaltigen ungesättigten Polyester und mindestens ein fotopolymerisierbares ethylenisch ungesättigtes Monomeres enthält.

6. Verfahren nach einem der Ansprüche 1 bis 5, dadurch gekennzeichnet, daß die haftvermittelnde Schicht H als Bindemittel ein Polyesterpolyurethan enthält.

7. Verfahren nach einem der Ansprüche 1 bis 6, dadurch gekennzeichnet, daß die haftvermittelnde Schicht durch Trocknen eines pigmentierten oder unpigmentierten Haftlacks bei 130 bis 240 °C hergestellt wurde.

8. Verfahren nach einem der Ansprüche 1 bis 7, dadurch gekennzeichnet, daß die haftvermittelnde Schicht H eine Stärke von 0,002 bis 0,150 mm aufweist.

9. Verfahren nach einem der Ansprüche 1 bis 8, dadurch gekennzeichnet, daß die reliefbildende Schicht R eine Stärke von 0,2 bis 3 mm aufweist.

**Claims**

1. A process for the production of photopolymer relief plates by applying a photosensitive relief-forming layer R of a mixture comprising a photopolymerizable ethylenically unsaturated compound and a

photoinitiator to a dimensionally stable base which bears an adhesive layer A for the layer R, exposing the layer R imagewise and subsequently removing the unexposed areas of the layer, wherein a layer R, containing from 0.000 01 to 5 percent by weight of a thermal polymerization inhibitor which, on ultraviolet irradiation, liberates nitrosyl free radicals is applied to an adhesive layer A which contains from 0.01 to 10 percent by weight of a compound

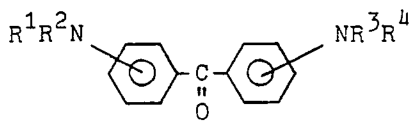

where $R^1$, $R^2$, $R^3$ and $R^4$ are identical or different and each is alkyl or $R^5$-(O-alkylene)$_x$-, $R^5$ being H or alkyl and x being 1, 2, 3, 4 or 5.

2. A process as claimed in claim 1, wherein the layer R contains N-nitrosodiphenylamine.

3. A process as claimed in claim 1 or 2, wherein the adhesive layer A contains Michler's ketone.

4. A process as claimed in any of claims 1 to 3, wherein a layer R which is liquid at room temperature is applied.

5. A process as claimed in any of claims 1 to 4, wherein the layer R contains an unsaturated polyester with carboxyl groups and at last one photopolymerizable ethylenically unsaturated monomer.

6. A process as claimed in any of claims 1 to 5, wherein the adhesive layer A contains a polyester polyurethane as binder.

7. A process as claimed in any of claims 1 to 6, wherein the adhesive layer A has been prepared by drying a pigmented or unpigmented adhesive at from 130 to 240 °C.

8. A process as claimed in any of claims 1 to 7, wherein the adhesive layer A has a thickness of from 0.002 to 0.150 mm.

9. A process as claimed in any of claims 1 to 8, wherein the relief-forming layer R has a thickness of from 0.2 to 3 mm.

**Revendications**

1. Procédé de fabrication de formes photopolymériques en relief par dépôt sur un support dimensionnellement stable, portant une couche d'adhérence H pour cette couche R, d'une couche R photosensible, destinée à produire un relief, d'un mélange d'une substance à insaturation éthylénique photopolymérisable et d'un photo-amorceur, exposition de la couche R à la lumière selon une image, puis élimination des parties non exposées de la couche, caractérisé en ce que l'on dépose une couche R, renfermant entre 0,000 01 et 5 % en poids d'un inhibiteur de la polymérisation thermique libérant sous l'action d'un rayonnement ultra-violet des radicaux nitrosyle, sur une couche d'adhérence H contenant entre 0,01 et 10 % en poids d'un composé de la formule

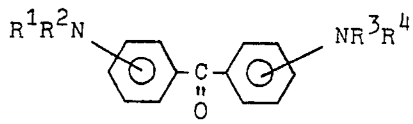

dans laquelle $R^1$ à $R^4$ désignent des radicaux alkyle ou des groupes $R^5$-(O-alkylène)$_x$, où $R^5$ = H ou alkyle et x vaut 1 à 5, identiques ou différents.

2. Procédé suivant la revendication 1, caractérisé en ce que la couche R contient de la N-nitroso-diphénylamine.

3. Procédé suivant la revendication 1 ou la revendication 2, caractérisé en ce que la couche d'adhérence H contient de la cétone de Michler.

4. Procédé suivant l'une des revendications 1 à 3, caractérisé en ce que la couche R déposée est en une matière liquide à la température ordinaire.

5. Procédé suivant l'une des revendications 1 à 4, caractérisé en ce que la couche R contient un polyester non saturé à groupes carboxyle et au moins un monomère à insaturation éthylénique photopolymérisable.

6. Procédé suivant l'une des revendications 1 à 5, caractérisé en ce que la couche d'adhérence H contient un polyester-polyuréthanne comme liant.

7. Procédé suivant l'une des revendications 1 à 6, caractérisé en ce que la couche d'adhérence H est préparée par séchage d'un vernis d'adhérence, pigmenté ou non, entre 130 et 240 °C.

8. Procédé suivant l'une des revendications 1 à 7, caractérisé en ce que la couche d'adhérence H possède une épaisseur comprise entre 0,002 et 0,150 mm.

9. Procédé suivant l'une des revendications 1 à 8, caractérisé en ce que la couche R, destinée à produire un relief, possède une épaisseur de 0,2 à 3 mm.